# EUROPEAN PATENT APPLICATION

(11) **EP 1 544 682 A2**
(43) Date of publication of application: **22.06.2005**
(21) Application number: 04029551.1
(22) Date of filing: 14.12.2004
(51) Int. Cl.: G03F 9/00

(54) **Exposure apparatus, alignment method and device manufacturing method**

(30) Priority: 15.12.2003 JP 2003416738
(71) Applicant: CANON KABUSHIKI KAISHA, Ohta-ku, Tokyo (JP)
(72) Inventor: Ohsaki, Yoshinori Canon Kabushiki Kaisha, Tokyo (JP)
(74) Representative: Leson, Thomas Johannes Alois, Dipl.-Ing.

(57) **Abstract**

An exposure apparatus for exposing a pattern on an exposure original onto a substrate using exposure light, includes a projection optical system for projecting the pattern on the exposure original onto the substrate, a first detection system that provides an alignment between the exposure original and the substrate in a plane orthogonal to an optical axis of the projection optical system, and a focus detecting system for detecting focusing condition of the projection optical system, the focus detection system includes a light intensity sensor for detecting light intensity of light which passed the projection optical system, wherein the focus detection system is calibrated based on the detection result of the first detection system.

## Description

The present invention relates generally to an exposure apparatus, alignment method and device manufacturing method, and more particularly to an exposure apparatus that exposes a pattern on an exposure original, such as a reticle, onto an object, such as a single crystal substrate of a semiconductor wafer, and an alignment method between them used for this exposure apparatus. The present invention is suitable, for example, for an exposure apparatus that exposes the single crystal substrate for the semiconductor wafer in a step and scan manner (scanning manner) in the photolithography process that utilizes extreme ultraviolet ("EUV") light.

A semiconductor exposure apparatus projects a pattern on a reticle or a photomask ("reticle" hereinafter) as an exposure original onto a substrate ("wafer" hereinafter) as an object to be exposed, such as a semiconductor wafer and a glass plate, onto which a photosensitive agent, such as a resist, is applied, via projection optical system. The recent trend of the exposure apparatus is shifted to a scanning exposure apparatus or a step-and-scan exposure apparatus that scans the reticle and wafer simultaneously relative to the projection optical system for exposure.

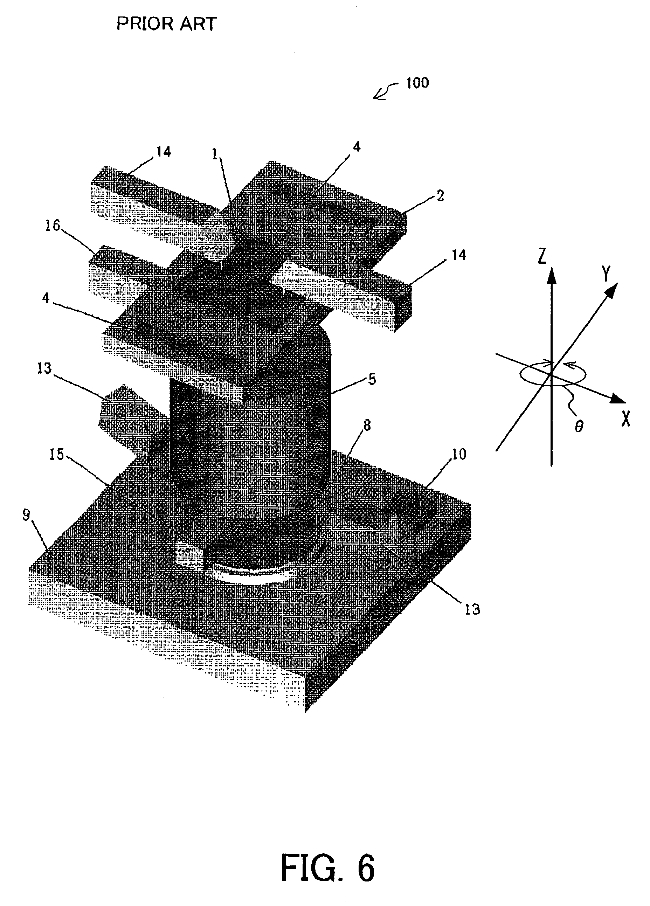

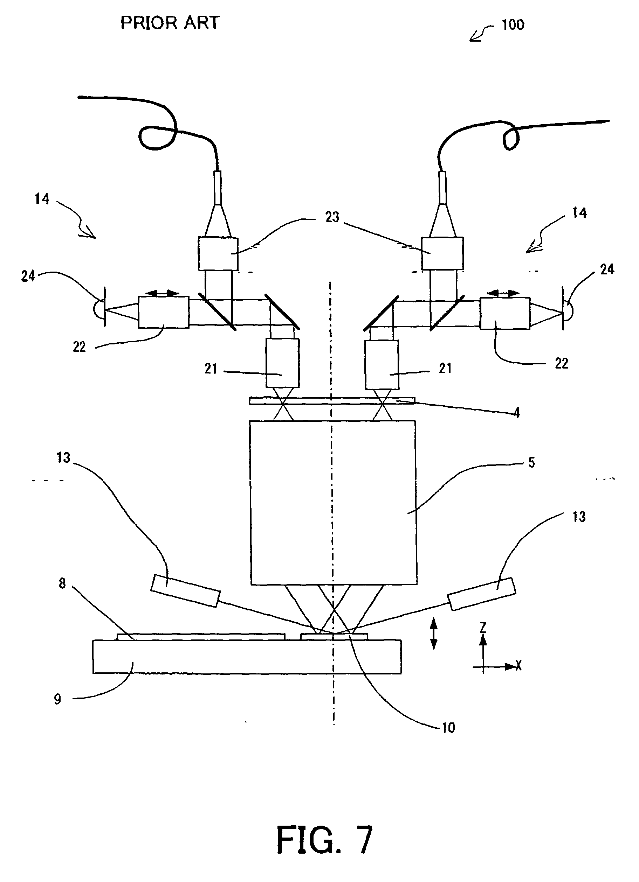

FIG. 6 is a schematic perspective view showing a structure of the conventional scanning exposure apparatus 100, and FIG. 7 is a block diagram of its schematic structure. A reticle 1 and a wafer 8 are arranged optically conjugate with each other via a projection optical system 5, and an illumination optical system 6 forms a rectangular or arc-shaped exposure area that is long in the X direction on the reticle 1. A pattern on the reticle 1 is exposed on the wafer 8 held by a wafer stage 9 as both of a reticle stage 2 and the wafer stage 9 are driven in a direction orthogonal to the exposure optical axis in a speed ratio corresponding to the optical magnification of the projection optical system 5. A detailed description will now be given of a structure of the scanning exposure apparatus.

The reticle 1 is held on the reticle stage 2. A reticle-stage laser interferometer and a drive controller means (not shown) controls driving of the reticle stage 2 in the Y direction in FIG. 6. A reticle-side (R-side) reference plate 4 is provided in a predetermined area near the reticle 1 on the reticle stage 2 so that the pattern surface of the R-side reference plate 4 is approximately level with the pattern surface of the reticle 1. Plural position measuring marks are formed by metal, such as Cr and Al, on the pattern surface of the R-side reference plate 4. The reticle stage 2 is driven while its position in the optical-axis direction (or Z direction) is maintained constant relative to the projection optical system 5. A moving mirror (not shown) that reflects a beam from a laser interferometer is fixed onto the reticle stage 2, and the laser interferometer sequentially measures a position and moving amount of the reticle stage 2.

A wafer-side (W-side) reference plate 10 is provided in a predetermined area near the wafer 8 on the wafer stage 9 so that the pattern surface of the W-side reference plate 10 is approximately level with the top surface of the wafer 8. Plural alignment marks are formed by metal, such as Cr and Al, on the pattern surface of the W-side reference plate 10. A drive controller means is provided to move the wafer stage 9 in the optical-axis direction (Z direction) of the projection optical system 5 and in the plane orthogonal to the optical-axis direction (XY plane), as well as rotating the wafer stage 9 around an axis parallel to the optical axis (θ direction). A moving mirror that reflects a beam from a wafer-stage laser interferometer (not shown) is fixed onto the wafer stage 9, and the laser interferometer sequentially measures a position and moving amount of the wafer stage 9.

A description will be given of a focal surface position detecting means. The exposure apparatus 100 includes a focus position detecting system 13 of an oblique incident system as a focal surface position detecting means. The focus position detecting system 13 obliquely irradiates the non-exposure light onto a wafer 8 surface (or a pattern surface of W-side reference plate), onto which the projection optical system 5 transfers a pattern on the reticle 1, and detects reflected light reflected obliquely from the wafer 8 surface (or the pattern surface of the W-side reference plate 10). The focus position detecting system 13 includes, as a detector, plural position detecting light-receiving elements corresponding to the reflected lights so that the light receiving surface of the position detecting light-receiving element and the reflecting point of the light on the wafer 8 are approximately conjugate to each other. Therefore, a positional offset of the wafer 8 (or the W-side reference plate 10) in the optical-axis direction of the projection optical system 5 is measured as a positional offset on the position detecting light receiving element in the detector.

However, an error occurs between the measuring origin of the focus position detecting system 13 and the focal surface of the projection optical system 5 as the projection optical system 5 absorbs the exposure heat or the surrounding environment changes. Accordingly, this error should be measured and corrected. This correction is called a focus calibration. In order to measure this error, a through the reticle ("TTR") detecting system using an image detecting method ("image detecting TTR system") 14 is provided.

As shown in FIGs. 6 and 7, the image detecting TTR system 14 includes two enlargement optical systems, each optical system includes an objective lens 21, a relay lens 22, an illumination section 23, an image pickup device 24, etc. The image detecting TTR system 14 enlarges the alignment mark on the reticle 1 or the R-side reference plate 4, and images it onto the image pickup device 24. The image detecting TTR system 14 also images the alignment mark on the wafer 8 or the W-side reference plate 10 onto the image pickup device 24 via the projection optical system 5 and the enlargement optical system, similar to the reticle.

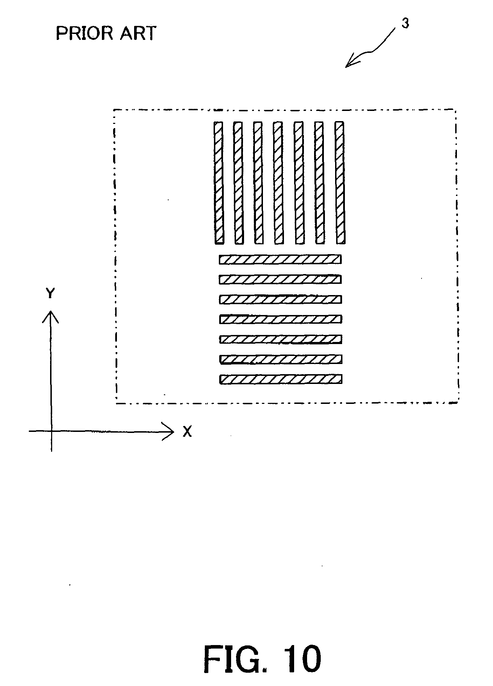

A description will now be given of a method for measuring an error between a measuring origin of the focus position detecting system 13 of the oblique incident system and the focal surface of the projection optical system 5 by using the image detecting TTR system 14. First, the light having substantially the same wavelength as that of the exposure light is introduced into the illumination section in the image detecting TTR system 14 using a fiber and an optical system (not shown), and illuminates a focus measuring mark (or an alignment mark) on the R-side reference plate 4 via the objective lens 21. The alignment mark 3 includes, for example, plural strips in the XY directions as shown in FIGs. 10.

Next, the relay lens 22, the objective lens 21 or the like in the image detecting TTR system 14 is driven in the optical-axis direction in the enlargement optical system so that the image pickup device 24 and the R-side reference plate 4 are conjugate with each other. Then, by driving the wafer stage 9, the image detecting TTR system 14 illuminates the focus measuring mark on the W-side reference plate 10 via the projection optical system 5 and makes it observable. While the focus position detecting system 13 of the oblique incident system measures a position of the W-side reference plate 10 in the optical-axis direction of the projection optical system 5, the wafer stage 9 is longitudinally driven in the optical-axis direction (or the Z direction) and a position is detected at which the image pickup device 24 and the W-side reference plate 10 are conjugate with each other in the image detecting TTR system 14.

In this case, since the image pickup device 24 and the R-side reference plate 4 are conjugate with each other, the W-side reference plate 10 and the R-side reference plate 4 are conjugate with each other or in the focus state of the projection optical system. The error between the measuring origin of the focus position detecting system 13 and the focal surface of the projection optical system 5 can be corrected by reading the measurement values of the focus position detecting system 13 at the focus state. This corrective action is the above focus calibration or Z-direction detection. The TTR's focus detection is disclosed, for example, in Japanese Patent Application, Publication No. 5-45889.

On the other hand, the image detecting TTR system 14 detects relative positions between the R-side reference plate 4 and W-side reference plate 10 on the plane perpendicular to the optical axis of the projection optical system. This position detection is used to calculate a baseline of the off-axis alignment optical system 15, an offset between the scan direction of the wafer stage and the scan direction of the reticle stage, etc., i.e., the calibrations in the XY directions (or XY-directions detections). The baseline is a distance on the XY plane between a shot center position in aligning the wafer, and a shot center position during exposure (a position along the optical axis projection optical system). A description will now be given of the summary of the baseline measurements of the off-axis alignment optical system 15 in the conventional scanning exposure apparatus.

In the baseline measurement in the conventional scanning exposure apparatus, the reticle stage 2 and the wafer stage 9 are driven to the predetermined position, and the image detecting TTR system 14 detects the relative positions of the R-side reference plate 4 and the W-side reference plat 10 (first step). The W-side reference plate 10 is moved to a detectable range of the off-axis alignment optical system 15 by driving the wafer stage 9, and the relative positions of the reference mark on the off-axis alignment optical system and the alignment mark on the W-side reference plate 10 ("W-side alignment mark" hereinafter) are detected (second step). The baseline of the off-axis alignment optical system 15 can be measured by the detecting results of the first and second steps.

The image detecting TTR system 14 illuminates the W-side alignment mark from the back surface of the W-side reference plate 10 (which is an opposite surface to a surface opposing to the projection optical system 5 or the bottom surface in FIG. 7), and images the W-side alignment mark onto the R-side reference plate 4 via the projection optical system 5. In addition, the image detecting TTR system 14 illuminates the alignment mark on the R-side reference plate 4 ("R-side alignment mark"), and images the light that passed the R-side reference plate 4 onto the image pickup device via the enlargement optical system.

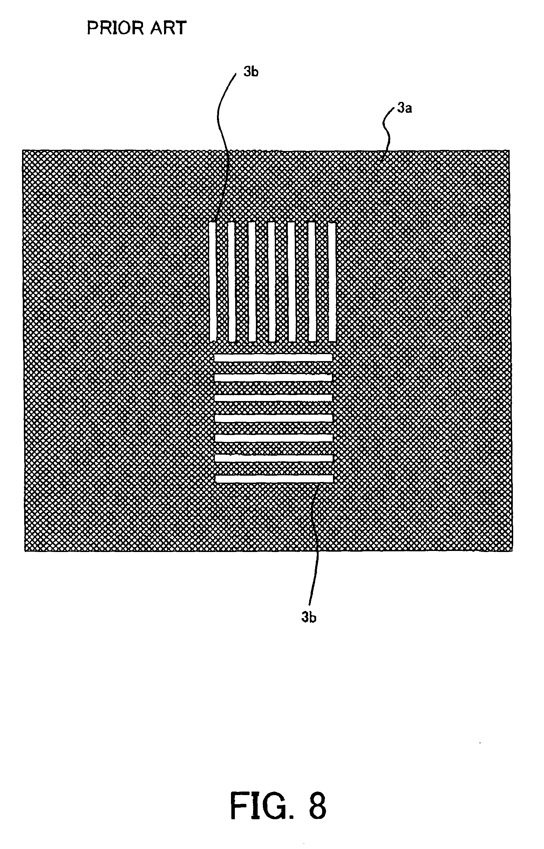

Another TTR detecting system uses a repetitive pattern of the light shielding parts 3a and the light transmitting parts 3b shown in FIG. 8 for the R-side and W-side alignment marks, and changes sizes of these mark based on the magnification of the projection optical system 5. This TTR detecting system illuminates this R-side alignment mark from the back surface side of the reticle 1 (the opposite surface side of the surface opposing to the projection optical system or the top surface side in FIG. 7), and projects the R-side alignment mark onto the W-side alignment mark via the projection optical system 5. Then, this TTR detecting system detects the light that transmits the W-side reference plate while moving the wafer stage or the reticle stage. This type of TTR detecting system is referred to as a light intensity detecting TTR system.

The recent high integration of the semiconductor devices demands the finer processing to patterns to be transferred or high resolution. The prior art has attempted to meet this requirement by using the exposure light having a short wavelength. However, only the short wavelength of the exposure light cannot satisfy the rapidly progressing integration of the semiconductor devices. For the high resolution, along with the short wavelength, the high numerical aperture ("NA") of the projection optical system has recently shifted from about 0. 6 to 0.8 or higher. This configuration, however, makes a depth of focus ("DOF") excessively small, and demands for the remarkably improved detecting accuracy of the focal point, in particular, improved accuracy of the focus calibration.

In the focus calibration that uses the image detecting TTR system, the NA of the enlargement optical system (such as the objective lens 21 and the relay lens 22 in FIG. 7) should be made higher as the NA of the projection optical system increases. When the NA of the projection optical system is smaller than the NA of the enlargement optical system, the DOF of the enlargement optical system in the image detecting TTR system is greater than the DOF of the projection optical system, and the focus fluctuations of the projection optical system due to the environmental variances cannot be detected precisely.

The high NA of the enlargement optical system makes a design of the enlargement optical system difficult. The high NA enlarges the size of the enlargement optical system itself, and the large enlargement optical system disadvantageously precludes the mounting of the image detecting TTR system onto the exposure apparatus.

In the calibration in the XY directions of the projection optical system, such as the baseline measurement, a size of one pixel (pixel resolution) of the image pickup device on the reticle or the wafer is a major factor that determines the measuring accuracy. While the magnification of the enlargement optical system is an important factor, its NA little affects the measuring accuracy. The alignment mark 3 used for the focus calibration is a mark that includes, for example, plural strips shown in FIG. 10, which corresponds to the transmitting part 3b of the alignment mark, and the critical dimension (or width) is preferably as close to the resolution limits of the projection optical system and the image detecting TTR system as possible.

However, the measuring accuracy is subject to the vibrational influence of the optical elements, such as an objective lens, in the enlargement optical system, when the magnification of the image detecting TTR system is made higher for precise measurements in the XY directions, or when the mark's critical dimension is made smaller for precise measurements in the Z direction. In particular, in the focus calibration, when the objective lens vibrates, for example, the effective critical dimension becomes thick by the vibration, and the intended effect is unavailable even when a mark having a small critical dimension is used.

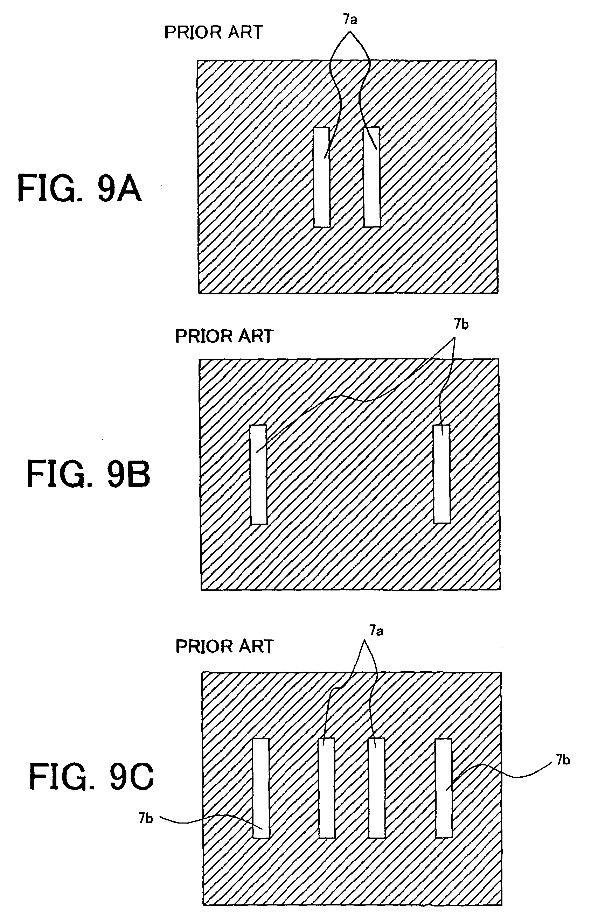

In the calibrations in the XY directions, it is possible to reduce the vibrational influence even when the optical element vibrates in the enlargement optical system, by simultaneously detecting a R-side alignment mark 7a shown in FIG. 9A and a W-side alignment mark 7B shown in FIG. 9B. This is because the simultaneous photographing of the R-side alignment mark 7a and the W-side alignment mark 7B provides a photographed image as shown in FIG. 9C, and these marks vibrate similarly under vibrations and the relative positional relationship between these marks is little subject to the vibrational influence.

On the other hand, the enlargement optical system is unnecessary if the TTR detecting system of the light intensity detecting system is used. No problems occur, such as a requirement of the high NA of the optical system and the vibrational influence. However, in advance to the measurements in the Z direction, it is necessary for this method to align the reticle-side mark's light transmitting part with the wafer-side mark's light transmitting part in the XY directions. A measurement in the Z direction while both marks in the XY directions are not aligned with each other would cause an offset and deteriorate the accuracy. On the contrary, measurements in the XY direction at a defocus position in the Z direction would cause an offset and deteriorate the accuracy. As a consequence, the stage should be moved in the XY directions and Z direction repetitively, resulting in the long measurement time period. In addition, the measurements of only the light intensity changes cannot provide correct detections if only one mark shifts in the measurements in the XY direction.

Both the image detecting TTR system and the light intensity detecting TTR system have conventionally used the exposure light for the focus calibration and the the calibration in the XY directions. The calibration frequency tends to increase as the accuracy required for the alignment becomes stricter. The running cost of the exposure light source increases as the exposure light's wavelength becomes shorter in order of the KrF and ArF excimer lasers and F₂ lasers. There is a contradicting demand for the reduced cost by reducing the number of calibrations.

Accordingly, it is an exemplary object of the present invention to provide an exposure apparatus that achieves a focus calibration of a projection optical system with high precision using a TTR alignment detecting system when the projection optical system has a high NA. Another exemplary object is to reconcile a calibration with the reduced influence of the running cost of the exposure light source.

An exposure apparatus according to one aspect of the present invention for exposing a pattern on an exposure original onto a substrate using exposure light, includes a projection optical system for projecting the pattern on the exposure original onto the substrate, a first detection system that provides an alignment between the exposure original and the substrate in a plane orthogonal to an optical axis of the projection optical system, and a focus detecting system for detecting focusing condition of the projection optical system, the focus detection system includes a light intensity sensor for detecting light intensity of light which passed the projection optical system, wherein the focus detection system is calibrated based on the detection result of the first detection system.

A device manufacturing method according to another aspect of the present invention includes the steps of exposing an object using the above exposure apparatus, and developing the object that has been exposed.

An alignment method according to still another aspect of the present invention for an alignment between an exposure original and a substrate in an exposure apparatus that illuminates the exposure original form and exposes a pattern on the exposure original onto the substrate via a projection optical system using exposure light, includes the steps of providing an alignment in a plane orthogonal to an optical axis of the projection optical system using a first detection system, and providing an focus detection of the projection optical system using a focus detection system including a light intensity sensor for detecting light intensity of light which passed the projection optical system, wherein the focus detection system is calibrated based on the detection result of the first detection system.

Other objects and further features of the present invention will become readily apparent from the following description of the preferred embodiments with reference to the accompanying drawings.
FIG. 1 is a block diagram of a schematic structure of an exposure apparatus according to a first embodiment of the present invention.
FIG. 2 is a flowchart for explaining a device manufacturing method by the exposure apparatus shown in FIG. 1.
FIG. 3 is a detailed flowchart for Step 104 of wafer process shown in FIG. 2.
FIG. 4 is a block diagram of a schematic structure of an exposure apparatus according to a second embodiment of the present invention.
FIG. 5 is a block diagram of a schematic structure of an exposure apparatus according to a third embodiment of the present invention.
FIG. 6 is a schematic perspective view of a conventional scanning exposure apparatus.
FIG. 7 is a block diagram a schematic structure of the exposure apparatus shown in FIG. 6.
FIG. 8 is a plane view showing one exemplary alignment mark for measurements in a Z direction.
FIGs. 9A, 9B and 9C are plane views showing one exemplary alignment mark for measurements in XY directions, wherein FIG. 9A shows a R-side alignment mark, FIG. 9B shows a W-side alignment mark, and FIG. 9C shows a photographed image when an image pickup device photographs both the R-side alignment mark and W-side alignment mark.
FIG. 10 is a pattern diagram for explaining a pattern of the alignment mark for measurements in the Z direction.

### FIRST EMBODIMENT

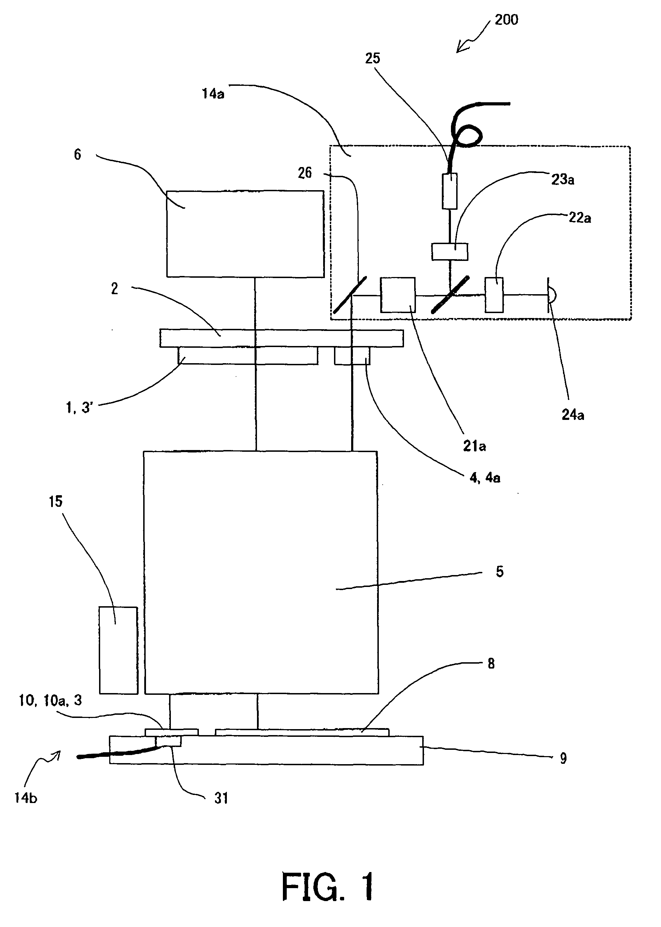

Referring now to the accompanying drawings, a description will be given of an exposure apparatus according to a first embodiment of the present invention. FIG. 1 is a block diagram of a schematic structure of the exposure apparatus 200. A difference between the exposure apparatus 200 and the conventional exposure apparatus 100 shown in FIG. 7 is that the exposure apparatus 200 includes two types of TTR detecting systems that use different detection methods, i.e., one type of detecting system for detecting a position in XY directions including an image detecting system (image detecting TTR system) 14a as a first optical system that uses an image pickup device for a sensor, and the other type of detecting system for detecting a position in the Z direction including a light intensity detecting system (light intensity detecting TTR system) as a second optical system.

The image detecting TTR system 14a for calibrations in XY directions includes, as shown in FIG. 1, an objective lens 21a, a relay lens 22a, an illumination section 23a, a fiber 25a, and an image pickup device 24a. A light source in the image detecting TTR system 14a uses the exposure light source in the first embodiment.

This embodiment introduces the light from the exposure light source (not shown) to the image detecting TTR system 14a's illumination section 23a through the fiber 25, etc., and illuminates the R-side alignment mark (R-side alignment mark for measurements in XY directions 4a) on the R-side reference plate 4. The objective lens 21a and the relay lens 22a enlarge the illuminated R-side alignment mark 4a, and the enlarged mark 4a is imaged on the image pickup device 24a, such as a CCD.

The light that has passed the R-side reference plate 4 and the projection optical system 5 illuminates the W-side alignment mark (W-side alignment mark for measuring the XY directions) 10a on the W-side reference plate 10 on the wafer stage 9. The projection optical system 5 images illuminated W-side alignment mark 10a onto the R-side reference plate 4, and the objective lens 21a, relay lens 22a, etc. in the image detecting TTR system 14a enlarge and image the light that has passed the R-side reference plate 4 onto the image pickup device 24a.

Use of the exposure light maintains an imaging relationship between the R-side alignment mark 4a and the W-side alignment mark 10a as in the relationship during the exposure time, and the same optical system or the projection optical system 5 can image the R-side alignment mark 4a and the W-side alignment mark 10a onto the image pickup device 24a. It is possible to calculate the positional relationship between the reticle 1 and the wafer 8 in the XY directions by calculating a position of the R-side alignment mark 4a on the image pickup device 24a and a position of the W-side alignment mark 10a on the image pickup device 24a.

While the instant embodiment forms the R-side alignment mark 4a on the R-side reference plate 4, the R-side alignment mark 4a may be formed on the reticle 1. Similarly, the W-side alignment mark 10a is not limited to the W-side reference plate 10, and may be formed on the wafer 8. The enlargement optical system in the image detecting TTR system 14a may add another optical system to improve the magnification in addition to the objective lens 21a and the relay lens 22a.

A description will now be given of detections in the Z direction with the light intensity detecting TTR system 14b. The light intensity detecting TTR system 14b includes a W-side reference plate 10, and a light intensity sensor 31, such as a photodiode. On the W-side reference plate 10, the alignment mark 3 that includes a repetitive pattern of the light shielding parts 3a and the light transmitting parts 3b shown in FIG. 8 is formed on a transparent substrate that transmits the light having the exposure wavelength (see FIG. 10). The light intensity sensor 31 is provided close to the bottom surface of the W-side reference plate 10. The light intensity detecting TTR system 14b further includes the projection optical system 5, the exposure illumination optical system 6, and the reticle 1 on which an alignment mark 3' similar to that for the wafer 8 is formed. Of course, the alignment mark 3 on the W-side reference plate 10 ("W-side alignment mark 3 for measurements in the Z direction" hereinafter) may be formed on the wafer 8, or the alignment mark 3' ("R-side alignment mark 3' for measurements in the Z direction" hereinafter) on the reticle 1 may be formed on the R-side reference plate 4. As discussed above, the size of the W-side alignment mark 3 and the size of the alignment mark 3' are adjusted based on the magnification of the projection optical system 5.

The exposure light from the illumination optical system illuminates the R-side alignment mark 3', and the projection optical system 5 projects an image of the R-side alignment mark 3' onto the W-side alignment mark 3. The light that passes the W-side alignment mark 3's light transmitting parts 3b reaches the light intensity sensor 31 among the lights that form an image of the projected R-side alignment mark 3'. The light intensity varies by moving the wafer stage 9 in the optical-axis direction of the projection optical system 5 (or Z direction). The best focus position of the projection optical system 5 can be defined as a position in the Z direction, which maximizes the light intensity detected by the light intensity sensor 31.

The conventional configuration that uses only the light intensity detecting system might possibly cause improper Z-direction measurements that are conducted while the alignment mark at the wafer side is offset in the XY directions from the alignment mark at the reticle side, and should repeat the Z-direction measurements several times by changing a position in the XY directions. On the other hand, the instant embodiment uses the image detecting TTR system 14a to detect a position in the XY directions as discussed above, and can calculate the best focus position with precision through only one Z-direction measurement, shortening the measuring time period.

For the image detecting TTR system 14a for XY detections, the magnifications of the alignment marks 4a and 10a to be imaged onto the image pickup device are major factors to determine the measurement resolution, and does not basically rely on the NA of the enlargement optical system in the image detecting TTR system 14a. Therefore, even when the projection optical system 5 has a high NA, the enlargement optical system may have a small NA, facilitating its design. In addition, the high NA does not enlarge the enlargement optical system, and the mounting onto the exposure apparatus becomes easy. When the image detecting TTR system is used for measurements in the Z direction, a vibrational problem of the optical element occurs in the enlargement optical system. On the other hand, the instant embodiment uses the light intensity detecting TTR system 14b for measurements in the Z direction, and no vibrational issues arise. Since the R-side alignment mark 4a and the W-side alignment mark 10a are simultaneously measured for the XY measurements, the measurement with little vibrational influence can be maintained similar to the conventional configuration.

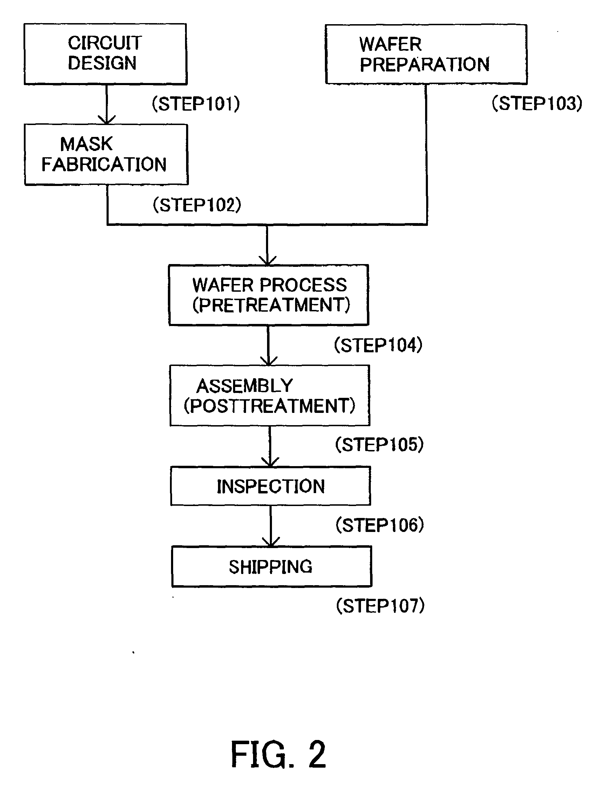

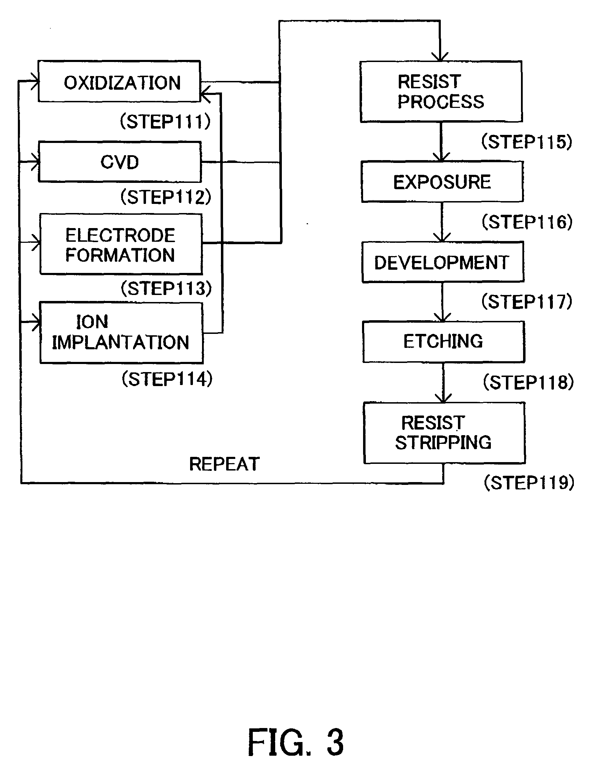

Referring now to FIGs. 2 and 3, a description will now be given of an embodiment of a device manufacturing method using the above exposure apparatus 200. FIG. 2 is a flowchart for explaining a fabrication of devices (i.e., semiconductor chips such as IC and LSI, LCDs, CCDs, etc.) . Here, a description will be given of a fabrication of a semiconductor chip as an example. Step 101 (circuit design) designs a semiconductor device circuit. Step 102 (mask fabrication) forms a mask having a designed circuit pattern. Step 103 (wafer preparation) manufactures a wafer using materials such as silicon. Step 104 (wafer process), which is referred to as a pretreatment, forms actual circuitry on the wafer through photolithography using the mask and wafer. Step 105 (assembly), which is also referred to as a post-treatment, forms into a semiconductor chip the wafer formed in Step 104 and includes an assembly step (*e*.*g*., dicing, bonding), a packaging step (chip sealing) , and the like. Step 106 (inspection) performs various tests for the semiconductor device made in Step 105, such as a validity test and a durability test. Through these steps, a semiconductor device is finished and shipped (Step 107).

FIG. 3 is a detailed flowchart of the wafer process in Step 104. Step 111 (oxidation) oxidizes the wafer's surface. Step 112 (CVD) forms an insulating film on the wafer's surface. Step 113 (electrode formation) forms electrodes on the wafer by vapor disposition and the like. Step 114 (ion implantation) implants ions into the wafer. Step 115 (resist process) applies a photosensitive material onto the wafer. Step 116 (exposure) uses the exposure apparatus 200 to expose a circuit pattern on the mask onto the wafer. Step 117 (development) develops the exposed wafer. Step 118 (etching) etches parts other than a developed resist image. Step 119 (resist stripping) removes disused resist after etching. These steps are repeated, and multilayer circuit patterns are formed on the wafer. The device manufacture method of the present invention may manufacture higher quality devices than the conventional one. Thus, the device manufacturing method using the inventive lithography, and resultant devices themselves as intermediate and finished products also constitute one aspect of the present invention.

### SECOND EMBODIMENT

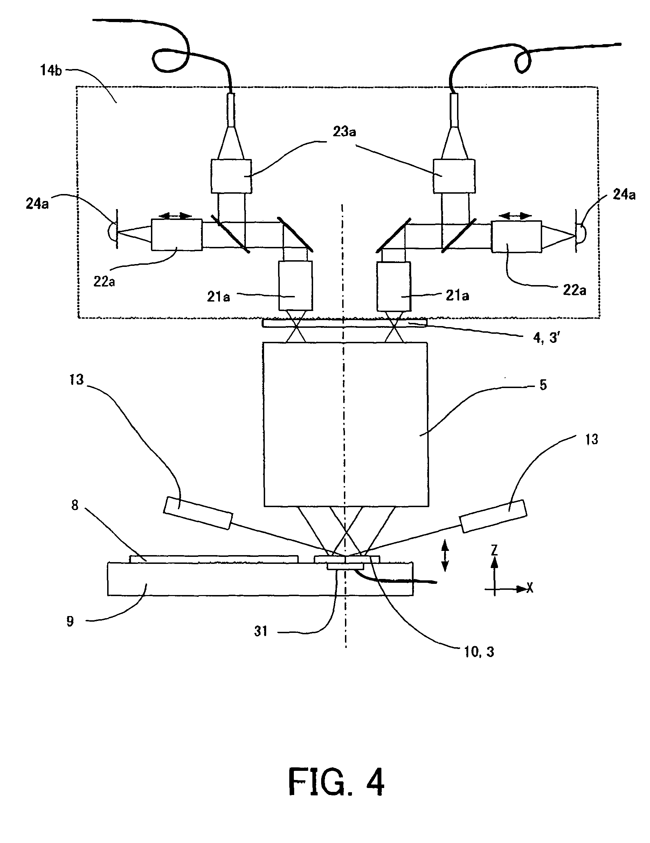

A description will be given of an exposure apparatus according to a second embodiment of the present invention, with reference to FIG. 4. The second embodiment provides the exposure apparatus with two image detecting TTR systems, and can measure rotations of the reticle 1 and wafer 8 around an axis (θ direction) parallel to the optical axis of the projection optical system 5. The two image detecting TTR systems 14b are arranged, as shown in FIG. 4, for XY measurements at two different positions in the exposure area of the projection optical system 5. In addition, the two image detecting TTR system 14b can provide simultaneous measurements.

The measurements in the XY directions at two different positions provide instant measurements of the rotational amounts of the reticle 1 and wafer 8 around an axis parallel to the optical axis of the projection optical system (θ direction), improving the measurement accuracy. As a result, the alignment accuracy in the XY directions improves further than the first embodiment without causing the long measuring time period. This configuration provides measurements in the Z direction in the light intensity detecting method while the R-side alignment mark 3' and the W-side alignment mark 3 used for the Z-direction measurements are aligned with each other with precision in the XY directions, improving the Z-direction calibration accuracy.

### THIRD EMBODIMENT

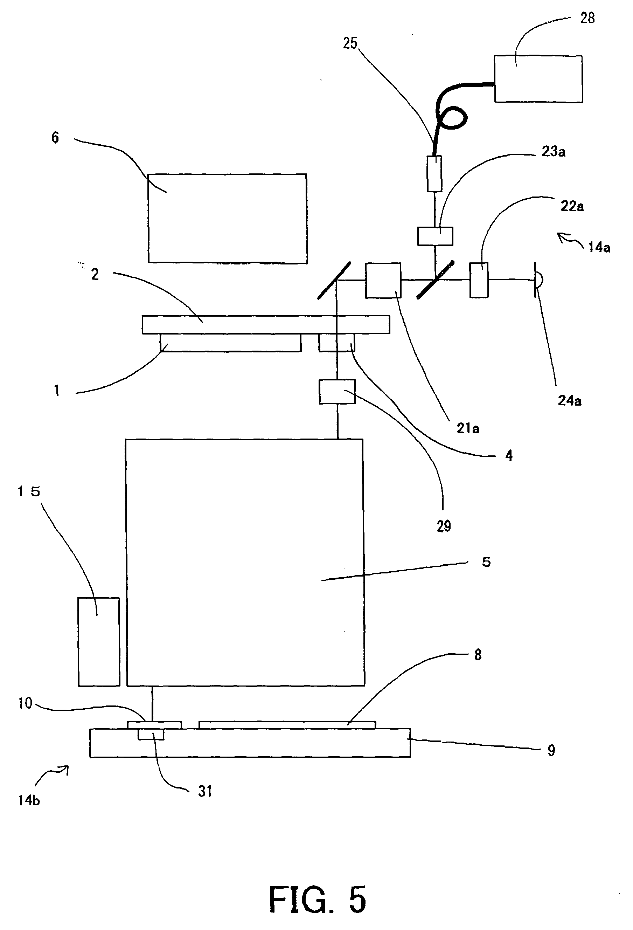

Referring to FIG. 5, a description will be given of an exposure apparatus of a third embodiment according to the present invention. This embodiment uses for the light source for the image detecting TTR system for measurements in the XY directions, a second light source 28 that emits the light having a wavelength different from that of the exposure light. The exposure light source's running cost remarkably increases as the wavelength of the exposure light source becomes shorter in order of the KrF laser, ArF laser, F₂ laser, and the EUV light in the exposure apparatus. On the other hand, when only the image detecting TTR system or only the light intensity detecting TTR system is used as in the prior art for XYZ calibrations, the light for the calibration needs to use the light having the same wavelength as that of the exposure light, because the inexpensive light having a longer wavelength than the exposure light lowers the sensitivity of the Z-direction detections according to a wavelength ratio.

On the other hand, as in the first embodiment, when the detection in the Z direction and the detection in the XY directions use different detecting systems, such as the light intensity detection TTR system and the image detecting TTR system, the inexpensive non-exposure light can be used for the detections in the XY directions (for the image detecting system). The detection accuracy in the XY directions depends mainly upon the magnification of the enlargement optical system used for the image detecting TTR system a size of the pixel in the image pickup device or the pixel resolution, and is little subject to the light's wavelength.

Accordingly, the third embodiment uses the exposure light for detections in the Z direction which have high sensitivity or the light intensity detecting TTR system 14b, and the inexpensive non-exposure light for detections in the XY directions or the image detecting TTR system 14a. Thereby, the expensive exposure light may be used only for calibrations in the Z direction, and the cost necessary for the calibration can be reduced by half. When the chromatic aberration occurs in the projection optical system 5 as a result of that the light source of the image detecting TTR system 14a uses the non-exposure light, the problem can be solved, for example, by providing a chromatic aberration correcting system 29 between the R-side reference plate 4 and the projection optical system 5.

It is difficult to correct the chromatic aberration over the entire NA of the projection optical system 5. In addition, as discussed above, the accuracy of the XY detections by the image detecting TTR system 14a depends upon the pixel resolution. Accordingly, the NA of the image detecting TTR system 14a is made smaller than the NA of the projection optical system 5 so as to correct the chromatic aberration by the reduced NA and to dramatically facilitate the aberrational correction. For example, when the exposure light that uses the EUV light for the exposure light, the projection optical system is made of only mirrors and the above chromatic aberration correcting system 29 is unnecessary. Accordingly, the method according to the third embodiment is effective which uses the exposure light only for the Z detections that has high wavelength sensitivity and the non-exposure light for the XY detections.

The TTR detecting system in the inventive projection exposure apparatus uses two types of detecting methods, and assigns the image detecting TTR system for detections in the XY directions and the light intensity detecting TTR system for detections in the Z direction. Therefore, the NA of the enlargement optical system used for the image detecting TTR system can be made smaller than the NA of the projection optical system. Thereby, the design of the enlargement optical system can become easy, and the entire enlargement optical system can be made so compact that it can be easily mounted on the exposure apparatus.

Even when the optical element in the enlargement optical system vibrates, the light intensity detecting TTR system that does not use the enlargement optical system is used for the Z detections that is easily subject to the vibrational influence, and the image detecting TTR system is used only for the XY measurements that is little affected by the vibrations. Therefore, the negative vibrational influence received by the enlargement optical system can be significantly reduced as low as possible.

A problem of an offset of one mark in the conventional light intensity detecting TTR system can be solved by the detections in the XY directions using the image detecting TTR system and the detections in the Z direction using the light intensity detecting TTR system. As a result of that plural image detecting TTR systems are provided for detections in the XY directions at plural points in the exposure area of the projection optical system, it is possible to measure the rotational amounts of the reticle and the wafer around an axis around the optical axis of the projection optical system, and the averaging effect at plural points improves the accuracy. As the non-exposure light different from the exposure light used for the exposure is used for the image detecting TTR system, the emitting frequency of the exposure light necessary for the calibration reduces and the running cost for the exposure apparatus can remarkably reduce.

Further, the present invention is not limited to these preferred embodiments, and various modifications and changes may be made in the present invention without departing from the spirit and scope thereof.

An exposure apparatus for exposing a pattern on an exposure original onto a substrate using exposure light, includes a projection optical system for projecting the pattern on the exposure original onto the substrate, a first detection system that provides an alignment between the exposure original and the substrate in a plane orthogonal to an optical axis of the projection optical system, and a focus detecting system for detecting focusing condition of the projection optical system, the focus detection system includes a light intensity sensor for detecting light intensity of light which passed the projection optical system, wherein the focus detection system is calibrated based on the detection result of the first detection system.

## Claims

1. An exposure apparatus that aligns an exposure original with a substrate, illuminates the exposure original using exposure light, and exposes a pattern on the exposure original onto the substrate via a projection optical system, said exposure apparatus **characterized in** comprising:
a first detection system that provides an alignment between the exposure original and the substrate in a plane orthogonal to an optical axis of said projection optical system; and
a focus detecting system for detecting focusing condition of the projection optical system, said focus detection system includes a light intensity sensor for detecting light intensity of light which passed the projection optical system,
wherein said focus detection system is calibrated based on the detection result of the first detection system.

2. An exposure apparatus according to claim 1, **characterized in that** said first detection system includes an image pickup device for photographing an image.

3. An exposure apparatus according to claim 1, **characterized in that** the alignment by said first detection system and the focus detection by said focus detection system use exposure-original alignment marks,
that the exposure-original alignment mark used for the alignment by said first detection system is different from that used for the focus detection by said focus detection system.

4. An exposure apparatus according to claim 3, **characterized in that** the exposure-original alignment mark is formed at least one of a holding member for holding the exposure original, the exposure original or a reference plate different from the exposure original held by the holding member.

5. An exposure apparatus according to claim 1, **characterized in that** the alignment by said first detection system and the focus detection by said focus detection system use substrate marks, and
that the substrate mark used for the alignment by said first detection system is different from that used for the focus detection by said focus detection system.

6. An exposure apparatus according to claim 5, **characterized in that** the substrate mark is formed at least one of a holding member for holding the substrate, the substrate or a reference plate different from the substrate held by the holding member.

7. An exposure apparatus according to claim 1, **characterized in that** said exposure light is extreme ultraviolet light.

8. An exposure apparatus according to claim 7, **characterized in that** said first detection system uses light having a wavelength between 150 nm and 370 nm.

9. An exposure apparatus according to claim 1, **characterized in that** there are plural first detection systems.

10. A device manufacturing method comprising the steps of:
exposing an object using an exposure apparatus according to claim 1; and
developing the object that has been exposed.

11. An alignment method for an alignment between an exposure original and a substrate in an exposure apparatus that illuminates the exposure original form and exposes a pattern on the exposure original onto the substrate via a projection optical system using exposure light, said alignment method comprising the steps of:
providing an alignment in a plane orthogonal to an optical axis of the projection optical system using a first detection system; and
providing an focus detection of the projection optical system using a focus detection system including a light intensity sensor for detecting light intensity of light which passed the projection optical system, wherein said focus detection system is calibrated based on the detection result of the first detection system.
